# EUROPEAN PATENT APPLICATION

(11) **EP 0 697 714 A1**
(43) Date of publication of application: **21.02.1996**
(21) Application number: 95305771.8
(22) Date of filing: 18.08.1995
(51) Int. Cl.: H01L 21/285

(54) **Method for forming gate electrode of semiconductor device**

(30) Priority: 18.08.1994 KR 9420433
(71) Applicant: Samsung Electronics Co., Ltd., Suwon-city, Kyungki-do (KR)
(72) Inventor: Paik, Choong-Ryul, Paldal-gu, Suwon-City, Kyungki-do (KR)
(74) Representative: Crawford, Fiona Merle

(57) **Abstract**

A method for manufacturing a titanium nitride (TiN) gate electrode of a semiconductor device includes the steps of: forming a gate insulating layer (14) on a semiconductor substrate (10); and forming a TiN layer (16) on the surface of the gate insulating layer by means of sputtering at a temperature of not less than 200°C and not more than 800°C. The gate electrode of the present invention has a low resistivity when compared with the conventional gate electrode.

## Description

The present invention relates to a method for forming a gate electrode of a semiconductor device, and more particularly, to a method for forming a gate electrode of a semiconductor device which improves a breakdown characteristic of a gate insulating layer by forming a gate electrode out of titanium nitride (TiN).

A metal-oxide semiconductor (MOS) transistor includes a source region and a drain region formed on a semiconductor substrate by implanting an impurity ion of the opposite conductivity to that of the substrate, a channel region formed between the source region and drain region, and a gate electrode formed on the channel region.

In general, the gate electrode of the MOS transistor is made of polysilicon into which an impurity is doped. When the gate electrode is formed of the doped polysilicon, the gate electrode formation process is accomplished with stability. However, the sheet resistance of the gate electrode formed of the doped polysilicon is high when compared to the case of forming the gate electrode out of another metal material. That is, the polysilicon constituting the gate electrode has a relatively high resistivity of about 1mΩ cm. Therefore, for MOS transistors, electrical signal transmission is delayed and power consumption is increased.

Also, as a semiconductor device becomes more and more integrated, the ensuing reduction in the pattern dimensions greatly increases the resistivity of the doped-polysilicon gate electrode, which deteriorates function and reliability of the device.

Meanwhile, when metal material having a lower resistivity than polysilicon is used for the material for forming a gate electrode, the gate electrode metal material is reacted with the gate insulating layer or diffused into the gate electrode itself, thereby to lower the breakdown voltage of the gate insulating layer.

Recently, as an example of a metal material having low resistivity, titanium nitride (TiN) is largely used as a barrier metal layer in the manufacturing process of a highly integrated semiconductor device, because of its relatively high melting point (about 3,000°C) and excellent diffusion barrier characteristics. Also, TiN has a work function ranging 4.63-4.75eV, which approximately mediates the work functions of other materials. Therefore, TiN has an advantage in that it enables N-channel as well as P-channel MOS transistors to operate as a surface-channel type device. Conventionally, however, when TiN is used for forming the gate electrode, it is deposited by reactive sputtering method at room temperature, and TiN layers thus formed have a high resistivity in the range of 0.2∼1mΩ cm, in stark contrast to a general bulky TiN layer having a resistivity of about 18µΩ cm. Here, the resistivity will vary according to TiN layer composition, surface state, micro-structures and impurity content.

An object of the present invention is to provide a method for forming a titanium nitride (TiN) gate electrode of a semiconductor device which can secure a reliable breakdown characteristic of the gate insulating layer as well as lowered resistivity.

According to the present invention, there is provided a method for forming a titanium nitride gate electrode of a semiconductor device comprising the steps of: (a) forming a gate insulating layer on a semiconductor substrate, and (b) forming a TiN layer on the surface of the gate insulating layer by means of sputtering at a temperature of not less than 200°C and not more than 800°C.

In an embodiment of the invention the step (b) further comprises the steps of forming a first TiN layer on the gate insulating layer by means of sputtering at a temperature of not less than 200°C and not more than 800°C and preferably at approximately 600° at a first forming rate, and forming a second TiN layer on the first TiN layer by means of sputtering at a temperature of not less than 200°C and not more than 800°C, and preferably at approximately 600°C at a second forming rate which is higher than the first forming rate.

It is possible that the TiN layer be formed in a mixed atmosphere of argon (Ar) and nitrogen (N₂) gases. Alternatively, it is possible that the first TiN layer be formed in a nitrogen gas atmosphere and the second TiN layer is formed in the mixed atmosphere.

In a preferred embodiment after depositing the second TiN layer, a metal material is further formed on the second TiN layer, thereby forming a gate electrode including the first and second TiN layers and the metal material. Here, it is preferable that the metal material having a relatively low resistivity is one selected from the group consisting of aluminium (Al), tungsten (W), tungsten silicide (WSiₓ), titanium silicide (TiSiₓ) and copper (Cu).

According to the present invention, it is possible to obtain a gate electrode having low resistivity and excellent breakdown characteristics of the gate insulating layer.

Embodiments of the present invention will now be described, by way of example, with reference to the accompanying drawings, in which:
FIG. 1 is a sectional view for illustrating a method for forming a TiN gate electrode according to an embodiment of the present invention;
FIG. 2 is a graph showing a resistivity characteristic of a TiN gate electrode relative to depositing temperature;
FIG. 3 is a graph showing the breakdown voltage characteristic of a gate oxide layer of respective TiN gate electrodes manufactured according to a conventional method and the present method;
FIG. 4 is a graph showing a constant current TDDB characteristic of a gate oxide layer of respective TiN gate electrodes manufactured according to a conventional method and the present method, and
FIG. 5 is a graph showing the variation of the inter-planar spacing of a TiN gate electrode in accordance with depositing temperature.

To describe the present invention in more detail, the characteristics of the TiN gate electrode according to embodiments of the present invention will be explained as compared with a TiN gate electrode formed by the conventional method at room temperature.

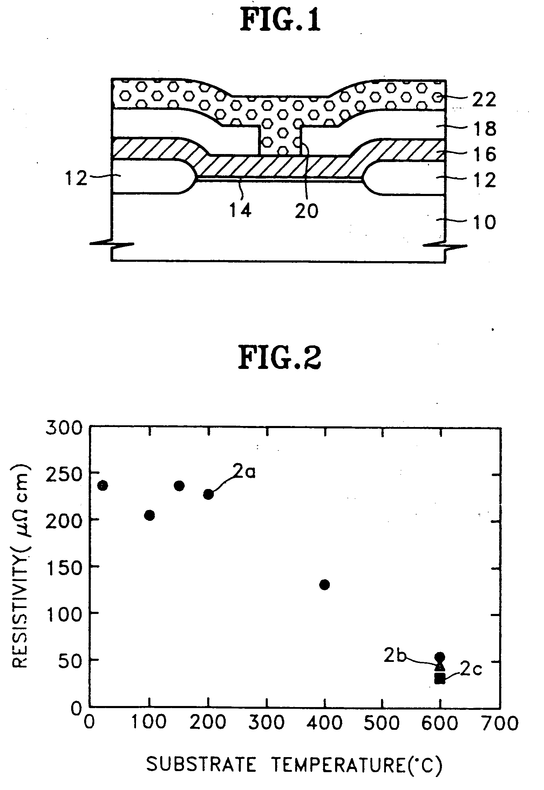

Referring to FIG. 1, a P-type silicon substrate 10 with a resistivity of 10Ω cm is subjected to a local oxidation of silicon (LOCOS) process, to form a device isolating region 12 defining an active region. Next, a thermal oxide layer with the thickness of about 80Å is grown on the active region to form a gate oxide layer 14. In an atmosphere temperature of not less than 200°C and not more than 800°C, and preferably at approximately 600°C in a 100% nitrogen atmosphere, a first TiN layer is thinly formed on gate oxide layer 14 by means of sputtering at a first forming rate. Thereafter, a second TiN layer is thickly formed on the first TiN layer by means of sputtering in a mixed atmosphere consisting of argon and nitrogen gases at a temperature of not less than 200°C and not more than 800°C, and preferably at approximately 600°C at a second forming rate being higher than the first forming rate, to form a TiN gate electrode 16. An insulating material, for example, undoped silicate glass (USG), with the thickness of about 2,000Å is then deposited on the overall surface of the resultant structure where TiN gate electrode 16 is formed, and TiN gate electrode 16 is heat-treated for about 30 minutes at about 450°C and in a nitrogen atmosphere. Next, a pattern is formed by using a 16M bits spider mask (not shown) with an area of 0.12cm, and a borophosphosilicate glass (BPSG) layer with the thickness of about 3,500Å is then formed. The resultant structure is reflowed for about 30 minutes in the nitrogen atmosphere at about 830°C, to form a BPSG/USG layer 18 which is then selectively etched to form a contact hole 20 for exposing TiN gate electrode 16. While filling the contact hole, a metal material, for example, one selected from the group consisting of aluminium (Al), tungsten (W), tungsten silicide (WSIₓ), titanium silicide (TiSiₓ) and copper (Cu), is deposited on the overall surface of BPSG/USG layer 18 and then patterned by using the spider mask. Consequently, a metal pattern 22 connected to TiN gate electrode 16 through contact hole 20 is formed.

According to another embodiment of the present invention, first, gate oxide layer 14 is formed and a TiN layer with the thickness of about 900Å is then formed on the surface of gate oxide layer 14 by direct-current magnetron sputtering in the mixed atmosphere of argon and nitrogen gases at a temperature of not less than 200°C and not more than 800°C, and preferably at approximately 600°C to form TiN gate electrode 16.

Then, to compare the TiN gate electrode formed by the above-described embodiments of the present invention with that formed at room temperature by the conventional method, the resistivity, breakdown voltage and time dependent dielectric breakdown (TDDB) characteristic of the gate oxide layer and inter-planar spacing are investigated.

FIG. 2 is a graph showing resistivity characteristic of a TiN gate electrode relative to depositing temperature. In FIG. 2, 2a represents the case of sputtering in a 60% nitrogen atmosphere, 2b represents the case of sputtering in a 80% nitrogen atmosphere, and 2c represents the case of sputtering in a 100% nitrogen atmosphere.

Referring to FIG. 2, the resistivity of the TiN gate electrode is decreased in accordance with the increase of the temperature of the substrate, and especially, sharply decreased at a temperature around 600°C. While the TiN gate electrode formed at room temperature by the conventional method has a high resistivity of about 200∼250µΩcm, the TiN gate electrode formed by two-step sputtering according to the present invention has a relatively low resistivity of about 36∼60µΩcm. Also, the TiN gate electrode formed in the mixed atmosphere of nitrogen and argon gases according to the present invention has a low resistivity of about 33∼53µΩ cm. The higher the content of a nitrogen gas of the atmosphere in which the TiN gate electrode is formed is, the more decreased the resistivity of the TiN gate electrode is. Therefore, the TiN gate electrode formed according to the present invention has lower resistivity than that formed according to the conventional method.

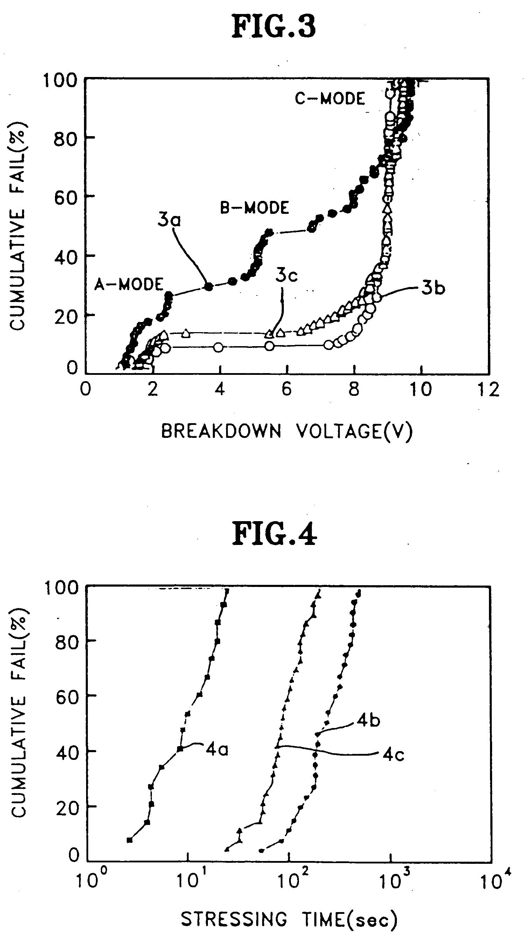

FIG. 3 is a graph showing the breakdown voltage of a gate oxide layer of respective TiN gate electrodes manufactured according to the conventional method and the present method. In FIG. 3, 3a represents a breakdown voltage of the TiN gate electrode formed at room temperature according to the conventional method, and 3b and 3c respectively represent breakdown voltage of the TiN gate electrode formed according to the embodiments of the present invention. That is, 3b represents a breakdown voltage of the TiN gate electrode formed by two-step sputtering and 3c represents that of the TiN gate electrode formed in the mixed atmosphere of nitrogen and argon gases. In general, a distribution of the breakdown voltage is classified into three kinds of mode. A mode A called as a tertiary peak is one due to a short circuit by the pin hole presented in the oxide layer. A mode B called as a secondary peak is one due to a weak spot of the oxide layer. A mode C called as a primary peak is one due to a intrinsic breakdown of the oxide layer.

Referring to FIG. 3, for the gate oxide layer of the conventional TiN gate electrode (refer to 3a) formed at room temperature, the defective ratio of mode A is about 27% and that of mode B is not less than 60%, both of which represent considerably high defective ratio. By contrast, for the gate oxide layer of the TiN gate electrode (refer to 3b) formed by two-step sputtering according to the present invention, the defective ratio of mode A is decreased to not more than 10% and mode B defective ratio is also remarkably decreased. Also, for the gate oxide layer of the TiN gate electrode (refer to 3c) formed in the mixed atmosphere of nitrogen and argon gases, mode A defective ratio is decreased to about 13% and mode B defective ratio is considerably decreased. As seen from these results, the gate oxide layer of the TiN gate electrode according to the present invention has a more improved breakdown voltage characteristic than the conventional one.

Here, the excellent breakdown voltage characteristic of the TiN gate electrode formed by two-step sputtering according to the present invention results from the fact that since the TiN layer is formed on the gate oxide layer by means of the sputtering in the 100% nitrogen gas atmosphere at low forming rate in the early forming TiN layer step to have stoichiometrical composition or a N-rich TiN layer containing nitrogen a bit is formed, the chance for diffusing metal titanium into the gate oxide layer is minimized.

FIG. 4 is a graph showing a constant current TDDB characteristic of a gate oxide layer of respective TiN gate electrodes manufactured according to the conventional method and the present method. In FIG. 4, 4a is to represent the conventional TiN gate electrode, and 4b and 4c are to respectively represent the TiN gate electrodes according to the embodiments of the present invention. That is, 4b represents the case of the TiN gate electrode formed by two-step sputtering and 4c represents the case of one formed in the mixed atmosphere of nitrogen and argon gases.

Referring to FIG. 4, for the TiN gate electrodes (4b and 4c, respectively) formed according to the first and the second embodiments of the present invention, the constant current TDDB characteristics of the gate oxide layer are considerably improved when compared with the conventional TiN gate electrode (4c) formed at room temperature. This results from the fact that the material forming a gate electrode is reacted with the gate oxide layer by heat-treatment or reduced to diffuse therein so that the TiN layer formed by the present invention has a considerably stable structure.

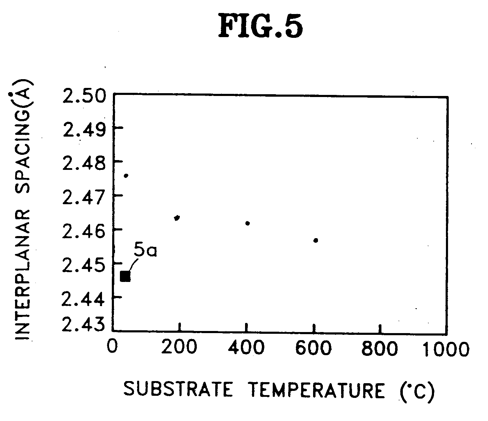

FIG. 5 is a graph showing the variation of the inter-planar spacing of a TiN gate electrode in accordance with depositing temperature. In FIG. 5, 5a represents standard value of the American Standard Test Method (ASTM) of the bulky TiN layer.

Referring to FIG 5, the inter-planar spacing relative to each temperature at which the TiN gate electrodes are formed is longer than the standard value. From the above results, it is known that the TiN lattice is expanded. Also, the inter-planar spacing is decreased in accordance with the increase of the temperature at which the TiN gate electrodes are formed, and finally, the inter-planar spacing of the TiN layer approaches the bulky TiN layer's level. That is, the TiN layer formed at a temperature of not less than 200°C and not more than 800°C and preferably at approximately 600°C tends to have a similar crystalline structure to the bulky TiN layer and have a more stable internal structure than the TiN layer formed at room temperature.

As described above, in the TiN gate electrode formed by two-step sputtering according to the present invention, it is possible to obtain the gate electrode having low resistivity and considerably improved breakdown voltage of the gate oxide layer when compared with the conventional gate electrode. Therefore, the metal gate electrode formed according to the present invention can be applied to the next generation semiconductor device.

The present invention is not limited to the above examples and many other variations are available to those skilled in this art.

## Claims

1. A method for manufacturing a titanium nitride (TiN) gate electrode of a semiconductor device comprising the steps of:
(a) forming a gate insulating layer (14) on a semiconductor substrate (10); and
(b) forming a TiN layer (16) on the surface of said gate insulating layer by means of sputtering at a temperature of not less than 200°C and not more than 800°C.

2. A method for manufacturing a TiN gate electrode of a semiconductor device as claimed in claim 1, wherein said step (b) further comprises the steps of:
forming a first TiN layer on said gate insulating layer by means of sputtering at a temperature of not less than 200°C and not more than 800°C at a first forming rate, and
forming a second TiN layer on the first TiN layer by means of sputtering at a temperature of not less than 200°C and not more than 800°C at a second forming rate.

3. A method for manufacturing a TiN gate electrode of a semiconductor device as claimed in claim 2, wherein said second forming rate is higher than said first forming rate.

4. A method for manufacturing a TiN gate electrode of a semiconductor device as claimed in claim 2 or 3, wherein said first TiN layer is deposited in a nitrogen atmosphere and said second TiN layer is deposited in a mixed atmosphere of argon and nitrogen gases.

5. A method for manufacturing a TiN gate electrode of a semiconductor device as claimed in any of claims 2 to 4, wherein, after depositing said second TiN layer, a metal material (22) is further formed thereon, thereby forming a gate electrode including said first and second TiN layers and said metal material.

6. A method for manufacturing a TiN gate electrode of a semiconductor device as claimed in claim 5, wherein said metal material is one selected from the group consisting of aluminium (Al), tungsten (W), tungsten silicide (WSiₓ), titanium silicide (TiSiₓ) and copper (Cu).

7. A method for manufacturing a TiN gate electrode of a semiconductor device as claimed in any one of claims 1 to 6, wherein said sputtering is performed at a temperature in the region of 600°C.
